# FASCICULE DE BREVET EUROPEEN

(11) **EP 2 721 650 B1**
(45) Date de publication et mention de la délivrance du brevet: **01.07.2015**
(21) Numéro de dépôt: 12726462.0
(22) Date de dépôt: 26.04.2012
(51) Int. Cl.: H01L 31/18, H01L 31/0216, H01L 31/068, H01L 21/225, H01L 21/268

(54) **Procédé de réalisation d'une cellule photovoltaïque a émetteur sélectif**
Verfahren zur Herstellung einer photovoltaischen Zelle mit selektivem Emitter
Method of making a photovoltaic cell with selective emitter

(30) Priorité: 17.06.2011 FR 1155352
(43) Date de publication de la demande: 23.04.2014
(73) Titulaire: Commissariat à l'Énergie Atomique et aux Énergies Alternatives, 75015 Paris (FR)
(72) Inventeur: PAVIET-SALOMON, Bertrand, F-69006 Lyon (FR); GALL, Samuel, F-56610 Arradon (FR); MANUEL, Sylvain, F-05230 Montgardin (FR)
(74) Mandataire: Cabinet Laurent & Charras
(86) Numéro de dépôt international: PCT/FR2012/050932
(87) Numéro de publication internationale: WO 2012/172226

(56) Documents cités:
- WO-A1-00/01019
- FR-A1- 2 943 180

## Description

### DOMAINE DE L'INVENTION

L'invention concerne un procédé de fabrication d'une cellule photovoltaïque à émetteur sélectif comprenant un substrat en silicium dopé p, ainsi que des zones de faible dopage et de fort dopage n.

Le domaine d'utilisation de la présente invention s'adresse en outre à la production d'électricité à partir d'énergie solaire et plus particulièrement des photons.

### ETAT ANTERIEUR DE LA TECHNIQUE

Le fonctionnement d'une cellule photovoltaïque est principalement basé sur l'absorption de photons engendrant le passage d'électrons entre la bande de valence et la bande de conduction d'un matériau aux propriétés semi-conductrices, constituant la cellule. Ce transfert d'électrons est rendu possible grâce au dopage du matériau constituant la cellule photovoltaïque, de manière à créer des zones présentant un excès d'électrons (dopage n) ainsi que des zones présentant un défaut d'électrons (dopage p).

De manière générale, une cellule photovoltaïque comporte un substrat en silicium dopé p recouvert d'une couche en silicium dopé n. Cet empilement constitue une jonction pn nécessaire à la collecte des photo-porteurs générés par l'exposition de la cellule photovoltaïque à la lumière solaire. La couche en silicium dopé n est par ailleurs recouverte d'une couche antireflet assurant une bonne absorption des photons. Cette dernière comprend des contacts électriques permettant la collecte du courant généré.

Cependant, certaines contraintes doivent être respectées, les zones de dopage n devant simultanément :
- assurer un bon contact ohmique avec les contacts électriques, et donc présenter un fort taux de dopage ;
- faciliter la passivation du matériau au moyen de la couche antireflet, et donc présenter un faible taux de dopage pour limiter les recombinaisons Auger qui sont liées à un fort taux de dopage.

En conséquence, des cellules photovoltaïques dites cellules à émetteur sélectif ont été développées. Ces cellules présentent des zones de fort dopage n ainsi que des zones de faible dopage n dans un substrat de type p.

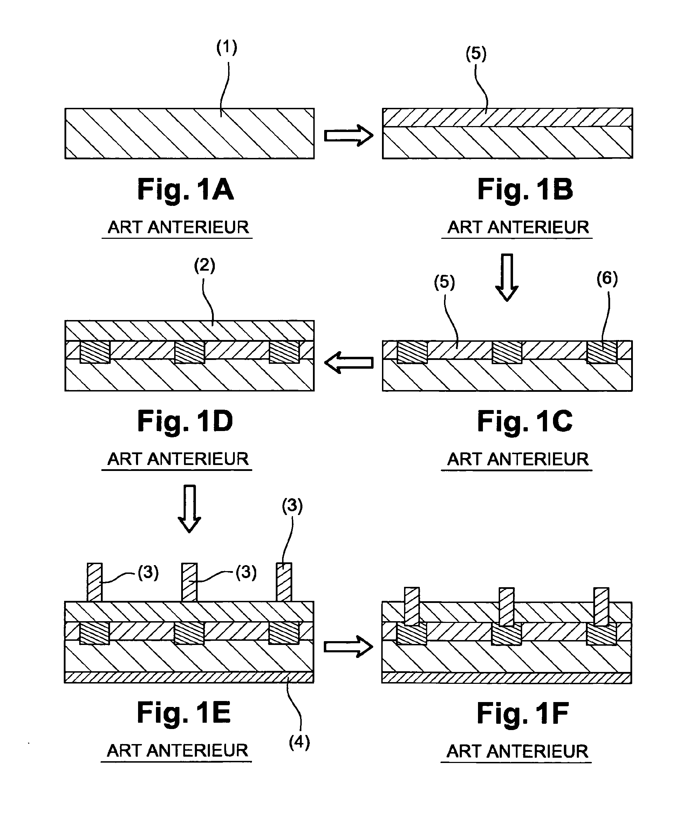

Les cellules photovoltaïques à émetteur sélectif de l'art antérieur (figure 1F) comportent donc une couche de faible dopage n, appelée également zone ou région n⁺ ou émetteur n⁺. En outre, dans ce type de cellule photovoltaïque, l'émetteur comprend également des zones de fort dopage n (régions n⁺⁺ ou émetteurs n⁺⁺) précisément définies pour réaliser des contacts électriques. L'émetteur n⁺ permet ainsi de faciliter la passivation par la couche antireflet et de réduire les recombinaisons Auger alors que l'émetteur n⁺⁺ est connecté aux contacts électriques afin d'assurer un bon contact ohmique.

Typiquement, les procédés de fabrication d'une telle cellule photovoltaïque à émetteur sélectif selon l'art antérieur comprennent les étapes suivantes :
- réalisation d'un émetteur n⁺ par diffusion gazeuse d'un dopant (POCl₃) au sein d'un substrat de silicium dopé p (J. C.C. Tsai, « Shallow Phosphorus Diffusion Profiles in Silicon », Proc. of the IEEE 57 (9), 1969, pp.1499-1506). Cette étape implique le maintien du substrat à une température voisine de 850 à 950°C pendant plusieurs dizaines de minutes (figures 1A et 1B) ;
- réalisation d'un émetteur n⁺⁺ par dopage laser (A. Ogane et al, « Laser-Doping Technique Using Ultraviolet Laser for Shallow Doping in Crystalline Silicon Solar Cell Fabrication », Jpn. J. Appl. Phys. 48 (2009) 071201), ou par une deuxième diffusion gazeuse d'un dopant (POCl₃) à une température plus élevée que celle mise en oeuvre dans le cas de l'émetteur n⁺ (figure 1C). Il s'agit de surdoper certaines zones précises de l'émetteur n⁺ ;
- dépôt d'une couche antireflet, typiquement du nitrure de silicium par PECVD (acronyme anglo-saxon pour « *Plasma Enhanced Chemical Vapor Déposition »*) (figure 1D) ;
- réalisation des contacts électriques par :
   - dépôt d'une grille de métallisation (contact n) sur la face supérieure du substrat. Il s'agit typiquement d'une pâte de sérigraphie à l'argent. Les motifs de cette grille de métallisation sont précisément alignés sur les émetteurs n⁺⁺ afin d'éviter de court-circuiter l'émetteur n⁺ lors du recuit des contacts (figure 1E). En effet, si la métallisation vient à se décaler au dessus de la zone n, cette dernière étant mince, lors du recuit, le métal peut la traverser et mettre en contact la zone n⁺ et le substrat.
   - dépôt d'une pâte contenant de l'aluminium (contact p) sur toute la face inférieure du substrat. Elle permet d'une part d'assurer le contact avec la partie dopée p de la cellule photovoltaïque, et d'autre part d'améliorer les propriétés électriques de cette dernière par BSF (de l'acronyme anglais *«Back Surface Field»*) c'est-à-dire par passivation par effet de champ (figure 1E). Il s'agit d'une couche de fort dopage p, permettant de repousser les électrons loin de la surface et de réduire la vitesse de recombinaison entre les électrons et les trous, et ce afin d'améliorer le rendement de la cellule ;
   - formation des contacts électriques par recuit simultané des pâtes (argent et aluminium) dans un four à passage, par exemple à une température de 885°C et avec une vitesse de tapis de 6500 mm/min (B. Sopori et al, « Fundamental mechanisms in the fire-through contact metallization of Si solar cells: a review », 17th Workshop on Crystalline Silicon Solar Cells & Modules: Materials and Process, Vail, Colorado, USA, August 5-8 2007). Cette étape de recuit est extrêmement critique, puisqu'il faut s'assurer qu'en une seule étape un bon contact ohmique est réalisé au niveau des faces supérieure et inférieure du substrat, et que la passivation de la face inférieure est assurée par effet BSF (figure 1F).

Dans les procédés selon l'art antérieur, et tels que par exemple décrits dans les documents FR 2 943 180 et WO 00/01019, l'étape de formation de l'émetteur n⁺ et celle du recuit des contacts n et des contacts p sont incompatibles et ne peuvent donc pas être réalisées simultanément. En effet, l'étape de formation de l'émetteur n⁺ par diffusion gazeuse d'un dopant (POCl₃) est relativement longue (plusieurs dizaines de minutes), et conduirait à court-circuiter les zones sous les contacts électriques si elle était réalisée après dépôt desdits contacts. D'autre part, les pâtes utilisées en sérigraphie, méthode utilisée pour réaliser les contacts électriques, sont incompatibles avec les fours utilisés pour la diffusion des dopants, car elles mettent en oeuvre de grandes quantités de métaux qui pollueraient irrémédiablement les fours de diffusion.

Les procédés de l'art antérieur comportent donc des étapes incompatibles, chacun nécessitant un apport énergétique bien spécifique. Au contraire, la présente invention permet de réduire ces contraintes énergétiques en combinant certaines étapes de la fabrication d'une cellule photovoltaïque à émetteur sélectif

### EXPOSE DE L'INVENTION

Le Demandeur a mis au point un procédé de réalisation d'une cellule photovoltaïque à émetteur sélectif dans lequel l'émetteur n⁺, les contacts n, les contacts p, et l'effet BSF sont réalisés simultanément au cours d'une unique étape de recuit. Ainsi, l'invention permet de remédier à certains problèmes de l'art antérieur liés à l'incompatibilité des étapes de recuit et de diffusion des dopants n.

Plus précisément, selon la revendication 1, la présente invention concerne un procédé de réalisation d'une cellule photovoltaïque à émetteur sélectif comprenant les étapes suivantes :
- dépôt d'une couche antireflet comprenant des dopants de type n sur un substrat de silicium de type p, ledit dépôt étant réalisé en présence d'un composé chimique permettant d'accélérer la diffusion des atomes dopants de type n dans le substrat de silicium de type n ;
- surdopage d'au moins une zone du substrat de manière à réaliser au moins un émetteur surdopé n⁺⁺ par diffusion ponctuelle des dopants n d'au moins une zone de la couche antireflet ;
- dépôt :
   ∘ d'au moins un matériau conducteur de contact n sur le au moins un émetteur surdopé n⁺⁺ ;
   ∘ d'au moins un matériau conducteur de contact p sur la face du substrat opposée à celle comprenant la couche antireflet ;
- réalisation des contacts n et des contacts p simultanément à la réalisation d'un émetteur n⁺ par un recuit apte à diffuser au sein du substrat des dopants n de la couche antireflet.

Des réalisations spécifiques sont définies dans les revendications dépendantes.

Lors du recuit assurant notamment la réalisation des contacts n et des contacts p, les dopants n des émetteurs surdopés n⁺⁺ peuvent également diffuser. En conséquence, le contact résultant est encore plus profond.

Par « diffusion ponctuelle », on entend que seuls les dopants n d'au moins une zone précise de la couche antireflet sont diffusés de manière à former des régions n⁺⁺ constituant les émetteurs n⁺⁺. Par ailleurs, lors de l'étape du recuit des contacts électriques, et donc de la formation de l'émetteur n⁺, cette au moins une zone de la couche antireflet dont les dopants n ont été diffusés pour former la ou les zones n⁺⁺, ne contribue pas à la formation de l'émetteur n⁺.

Le type du silicium est défini par la métallurgie du lingot d'origine du substrat utilisé lors de la cristallisation. Typiquement, le silicium de type p est dopé par le bore et le silicium de type n est dopé par le phosphore.

Selon un mode de réalisation particulièrement préféré, la couche antireflet est réalisée en nitrure de silicium, avantageusement par PECVD (acronyme anglo-saxon pour *« Plasma Enhanced Chemical Vapor Déposition* » ou dépôt en phase vapeur activé par plasma). En outre, elle est dopée n, préférentiellement au phosphore, en général au cours du dépôt, par exemple à l'aide d'un gaz dopant. Après l'étape de recuit assurant notamment la réalisation des contacts n et des contacts p, la couche antireflet peut éventuellement ne plus être dopée.

Le composé chimique permettant d'accélérer la diffusion des atomes dopants de type n est avantageusement l'ammoniac. Sans émettre une quelconque théorie, il est possible que la couche de nitrure de silicium obtenue en présence d'ammoniac, NH₃, est moins dense que les couches en nitrure de silicium de l'art antérieur, obtenues en présence d'azote, N₂. Les dopants n, atomes de phosphore, peuvent ainsi se déplacer plus librement.

Les zones n⁺⁺ peuvent être réalisées notamment par dopage laser, avantageusement par irradiation à l'aide d'un laser pulsé, et plus avantageusement encore d'un laser pulsé dont la longueur d'onde peut être choisie dans le domaine s'étendant de l'ultraviolet à l'infrarouge. Selon un mode de réalisation préféré, le laser présente une longueur d'onde sensiblement égale à 515 nm. L'étape du dopage laser peut éventuellement conduire à une ablation partielle de la couche antireflet.

Les zones n⁺⁺ permettent d'assurer un bon contact au niveau de la face supérieure du substrat, tout en évitant tout court-circuit. En effet, les zones n⁺⁺ sont très profondes et sont réalisées préalablement à l'étape de réalisation des contacts électriques par recuit des matériaux conducteurs n et p. Elles se situent à une profondeur avantageusement supérieure à 0,5 micromètre par rapport à la face supérieure de la couche antireflet. Elles sont avantageusement plus profondes que les zones n⁺.

Lors de l'étape de dopage laser assurant la formation de l'émetteur n⁺⁺, la durée des impulsions laser est préférentiellement comprise entre 10 ps et 1 µs.

Selon un mode de réalisation avantageux, les matériaux conducteurs de contact n et p sont déposés par sérigraphie. Cette technique consiste à déposer une pâte sur le substrat préalablement recouvert d'un masque. La pâte est ensuite poussée par une racle selon une vitesse et une pression réglables. Les propriétés du masque et notamment son épaisseur sont définies en fonction des contacts électriques à former. Dans le cas des contacts n, ces pâtes contiennent avantageusement peu de fritte de verre afin de limiter les risques de court-circuit.

De manière générale, l'épaisseur du substrat est comprise entre 50 micromètres et 500 micromètres alors que la couche antireflet présente une épaisseur comprise entre 20 et 100 nano mètres.

De manière avantageuse, dans le procédé selon la présente invention, l'émetteur n⁺ et les contacts électriques n et p sont réalisés simultanément par recuit dans un four infrarouge. Cette étape est préférentiellement accomplie à une température comprise entre 850 et 1050°C, et à une vitesse de passage du substrat dans le four avantageusement comprise entre 2000 et 6500 mm/min. En outre, la durée de passage dans le four est avantageusement comprise entre 1 s et 60 s.

En conséquence, il est particulièrement avantageux que la source dopante puisse être stable à l'air afin de pouvoir notamment être diffusée lors du passage du substrat dans un four.

Dans le procédé selon la présente invention, la présence d'un composé chimique permettant d'accélérer la diffusion des atomes dopants de type n est cruciale. En effet, ce composé assure une plus grande mobilité dans les étapes de dopage, et notamment lors de la réalisation des contacts électriques par recuit des matériaux conducteurs n et p, étape durant laquelle l'émetteur n⁺ est formé par diffusion des atomes dopant n.

Une cellule photovoltaïque susceptible d'être obtenue selon le procédé de réalisation selon la présente invention décrit ci-avant comprend un substrat en silicium de type p contenant au moins :
- un contact p positionné sur la face inférieure du substrat ;
- un émetteur n⁺ ;
- une couche antireflet positionnée sur la face supérieure du substrat ;
- au moins un émetteur n⁺⁺ sur lequel est positionné un contact n physiquement indépendant de la couche antireflet et de l'émetteur n⁺.

Il est a à noter que la combinaison des étapes concernant la diffusion de l'émetteur n⁺ et la réalisation des contacts par recuit est contraire à l'enseignement de l'art antérieur, étant donné qu'elles mettent en oeuvre des contraintes énergétiques bien distinctes. En effet, la formation de l'émetteur n⁺ par diffusion est généralement réalisée dans un four sous vide à la température de 850°C pendant 30 minutes, alors que le recuit des contacts électriques est réalisé à l'air libre et à des températures de 800 à 900°C pendant 3 minutes seulement. Bien que les températures de ces deux procédés restent similaires, les durées respectives de recuit varient selon un rapport de 1/10. En effet, l'apport énergétique nécessaire à la réalisation des contacts électriques n et p par recuit des matériaux conducteurs est très largement inférieur à celui nécessaire à la formation de l'émetteur n⁺ par diffusion. Cette différence s'explique majoritairement par le fait que les particules dopantes (et par exemple le phosphore) diffusent très lentement dans le silicium, ce qui nécessite des durées très longues pour parvenir à créer un émetteur n⁺ suffisamment dopé pour assurer un bon rendement. Au contraire, les particules métalliques assurant les contacts électriques (particulièrement en argent ou en aluminium) diffusent beaucoup plus rapidement. La réalisation des contacts électriques par recuit nécessite donc un apport énergétique moins important et donc une durée de recuit inférieure par rapport à la diffusion des dopants n. Il est par ailleurs important de s'assurer que la durée de recuit reste courte afin d'éviter que les particules métalliques diffusent trop profondément et traversent complètement l'émetteur n⁺, ce qui conduirait à un très mauvais rendement de la cellule (cellule court-circuitée).

Dans les procédés selon l'état de l'art, et contrairement à la présente invention, les contacts métalliques ne peuvent pas être déposés préalablement à la formation de l'émetteur n⁺ par diffusion dans un tube de diffusion traditionnel (i.e. en quartz et sous vide). En effet, il en résulterait une pollution du tube de diffusion par relargage des particules métalliques contenues dans les contacts eu égard aux températures élevées utilisées et notamment à la durée nécessaire au procédé de diffusion.

Dans le procédé selon la présente invention, cette combinaison est rendue possible par la présence d'un composé chimique, avantageusement de l'ammoniac, permettant d'accélérer la diffusion des atomes dopants n dans des conditions moins énergétiques. Ainsi, un émetteur n⁺ de bonne qualité, c'est-à-dire permettant d'obtenir des Voc > 620 mV, peut être obtenu par diffusion des atomes, notamment de phosphore, lors de l'étape de recuit, et ce malgré la courte durée de diffusion par rapport aux procédés classiques de l'art antérieur. La Voc représente la tension en circuit ouvert, il s'agit d'une caractéristique électrique de la diode.

L'homme du métier saura par ailleurs ajuster les durées des différentes étapes de diffusion et de recuit en fonction de la composition de la cellule photovoltaïque. En effet, la durée du recuit dépend notamment de la température mais aussi du dopant, et des contacts électriques et vice versa.

L'invention et les avantages qui en découlent ressortiront mieux des figures et exemples suivants donnés à titre indicatif et non limitatif à l'appui des figures suivantes.

### DESCRIPTION DES FIGURES

Les figures 1A à 1F illustrent les étapes de la réalisation d'une cellule photovoltaïque à émetteur sélectif selon l'art antérieur.
La figure 1F représente une cellule photovoltaïque à émetteur sélectif de l'art antérieur.
Les figures 2A à 2E illustrent les étapes de la réalisation d'une cellule photovoltaïque à émetteur sélectif selon la présente invention.
La figure 2E représente une cellule photovoltaïque à émetteur sélectif obtenue par le procédé de réalisation selon l'invention.

### DESCRIPTION DETAILLEE DES FIGURES

Les étapes du procédé de réalisation d'une cellule photovoltaïque à émetteur sélectif selon l'art antérieur sont décrites ci-dessous à la lumière des figures 1A à 1F. Ces figures représentent plus particulièrement les vues en coupe d'une cellule photovoltaïque selon l'art antérieur lors des différentes étapes de fabrication. Dans cet exemple, le substrat est de type p.

La figure 1A représente un substrat de silicium type p (1).

Sur la figure 1B, un émetteur n⁺ (5) est réalisé par dopage n du substrat (1). Il peut notamment s'agir d'un dopage par diffusion gazeuse en présence de POCl₃, dans le cas d'un dopage n au phosphore. Cette étape consiste donc à maintenir le substrat à une température de 850 à 950°C pendant plusieurs dizaines de minutes, la diffusion du dopant étant relativement lente.

Ensuite, la figure 1C illustre la réalisation d'un émetteur n⁺⁺ (6) par dopage laser. Cette étape peut également être réalisée par mise en oeuvre d'une deuxième diffusion gazeuse du dopant (POCl₃). Cependant, dans ce cas, la température serait plus élevée que celle à laquelle l'émetteur n⁺ (5) de la figure 1C est réalisé. Ainsi, certaines zones de l'émetteur n⁺ sont surdopées.

La figure 1D représente le dépôt d'une couche antireflet (2), typiquement du nitrure de silicium par PECVD.

La dernière étape du procédé selon l'art antérieur concerne la réalisation des contacts électriques (3) et (4) telle que illustrée par les figures 1E et 1F.

Tout d'abord, une grille de métallisation est déposée sur la face supérieure du substrat de manière à préparer les contacts n (3). Il s'agit typiquement d'une pâte de sérigraphie à l'argent.

Ensuite, une pâte contenant de l'aluminium est déposée sur toute la face inférieure du substrat de manière à préparer les contacts p (4). Cette pâte permet d'une part d'assurer le contact avec la partie dopée p de la cellule photovoltaïque, et d'autre part d'améliorer les propriétés électriques de cette dernière par BSF.

La formation des contacts électriques est finalisée par recuit simultané des pâtes (argent et aluminium) dans un four à passage, par exemple à une température de 885°C et avec une vitesse de tapis de 6500 mm/min afin de donner la cellule photovoltaïque à émetteur sélectif de l'art antérieur telle que représentée par la figure 1F.

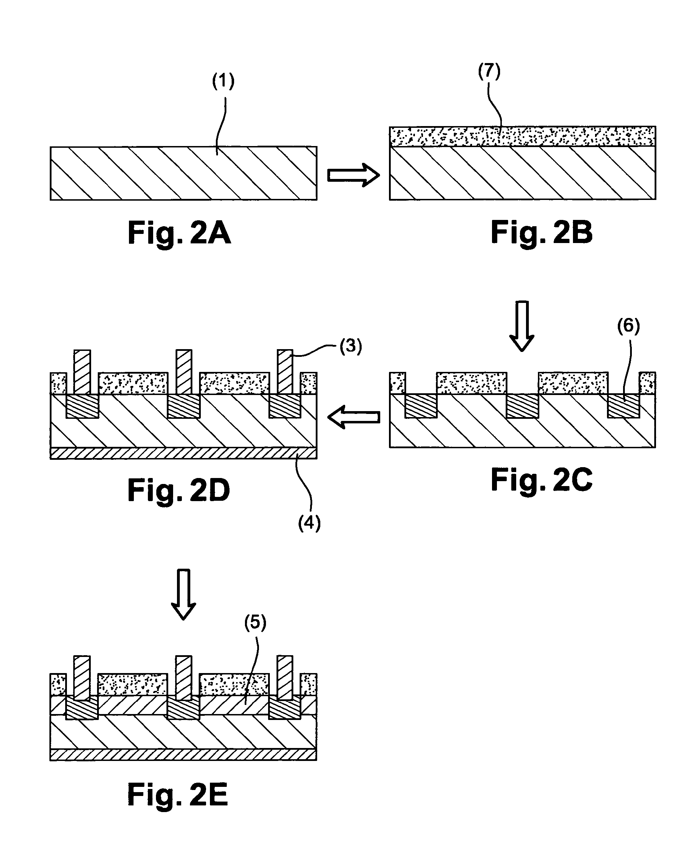

Les différentes principales étapes du procédé de réalisation d'une cellule photovoltaïque à émetteur sélectif selon la présente invention sont décrites ci-dessous à la lumière des figures 2A à 2E. Ces figures représentent plus particulièrement les vues en coupe d'une cellule photovoltaïque lors des différentes étapes de réalisation selon l'invention.

La figure 2A représente un substrat (1) de silicium type p, c'est-à-dire un substrat présentant un déficit d'électrons, donc un excès de trous considérés comme positivement chargés. Ce substrat est généralement obtenu par dopage d'un substrat en silicium à l'aide d'atomes appartenant à la colonne précédente du tableau périodique des éléments, tel que le bore.

La figure 2B illustre le dépôt d'une couche antireflet dopée n (7) sur le substrat de silicium type p (1). Cette couche antireflet (7) diffère de la couche antireflet (2) de la figure 1D (art antérieur) en ce qu'elle comprend des dopants de type n, c'est-à-dire des atomes présentant un excès d'électrons négativement chargés. Il peut s'agir d'une couche de nitrure de silicium dopée avec des atomes de phosphore. Le dépôt de SiN est généralement réalisé par PECVD à l'aide d'un mélange NH₃/SiH₄ et en présence d'un flux de phosphine PH₃. L'ammoniac est utilisé en tant que gaz précurseur, permettant en outre d'améliorer la mobilité des atomes de phosphore. Typiquement le rapport molaire NH₃/SiH₄ est compris entre 1 et 20.

Le substrat en silicium dopé p est donc recouvert d'une couche de nitrure de silicium dopé n. Contrairement à l'art antérieur, la couche antireflet est dopée n.

La figure 2C représente la formation de zones n⁺⁺ (6) surdopées au sein du substrat. Les zones n⁺⁺ (6) peuvent être réalisées par irradiation laser, de préférence par laser pulsé, la durée des impulsions étant de l'ordre de quelques dizaines de nanosecondes. La longueur d'onde du laser peut être choisie dans le domaine s'étendant de l'ultraviolet (laser excimère à 308 nm par exemple) à l'infrarouge (laser solide à 1064nm par exemple). Il s'agit préférentiellement d'un laser dont la longueur d'onde est sensiblement égale à 515 nm.

La couche antireflet (7) dopée n est irradiée localement, de manière à créer des zones fortement dopées.

Selon ce mode de réalisation particulier, le dopage laser est associé à l'ablation partielle de la couche antireflet. Cependant, cette ablation n'est pas essentielle au sens de la présente invention.

La figure 2D représente le dépôt des matériaux conducteurs constituant les contacts électriques sur les zones n (contacts n (3)) et sur la zone p (contact (4)). Pour plus de clarté, sur les figures 2D et 2E, les annotations (3) et (4) désignent les matériaux conducteurs, c'est-à-dire les contacts électriques avant recuit, et les contacts électriques réalisés après recuit.

Le matériau conducteur constituant les contacts n (3), typiquement en argent, est déposé sur les émetteurs n⁺⁺ (6). Bien que la figure 2E illustre des contacts n (3) n'étant pas en contact avec la couche antireflet (7), ils peuvent également être en contact avec la couche antireflet (7) selon un autre mode de réalisation de l'invention non présentement illustré. En général, les contacts p (4) sont réalisés en aluminium. Les contacts électriques permettent de collecter le courant généré ultérieurement par la cellule photovoltaïque.

Contrairement à l'art antérieur, à ce stade du procédé, l'émetteur n⁺ (5) n'a pas encore été réalisé. En effet, la figure 2E concerne la réalisation de l'émetteur n⁺ (5) par diffusion des dopants de la couche antireflet (7) en nitrure de silicium dopé n, simultanément à la réalisation des contacts n (3) et des contacts p (4) par recuit.

Cette étape consiste à faire diffuser, en une seule étape à haute température, les dopants contenus dans la couche antireflet en SiN:P (7) afin de réaliser l'émetteur n⁺ (5), tout en réalisant les contacts électriques par recuit des contacts n (3) et des contacts p (4), et l'activation du BSF.

Cette étape peut être réalisée dans un four à passage infrarouge.

### EXEMPLES DE REALISATION DE L'INVENTION

Une cellule photovoltaïque à émetteur sélectif est réalisée selon les étapes suivantes :
1. La surface d'un substrat en silicium de type p est texturée chimiquement par trempage pendant 40 minutes dans une solution aqueuse, comprenant 7% en volume d'isopropanol, de potasse (KOH 1%) à 80°C.
2. Une couche antireflet de 75 nm d'épaisseur réalisée en nitrure de silicium dopé au phosphore, SiN:P (50 sccm de PH₃), est déposée sur la face supérieure du substrat dopé p par PECVD (13.56 MHz à 300°C) en présence d'un flux de NH₃ de manière à ce que le rapport de flux NH₃/SiH₄ soit compris entre 1 et 20 sccm (selon l'acronyme anglo-saxon « *Standard Cubic Centimeters per Minute* » ou centimètres cubes standard par minute).
3. Des zones de la couche antireflet sont sélectivement irradiées pour former, par dopage laser, l'émetteur n⁺⁺. Ce dopage laser est réalisé au moyen d'un laser pulsé présentant une longueur d'onde de 515 nanomètres. La durée des impulsions est de 20 ns, avec une cadence de 300 kHz, correspondant à une puissance de 1.7 W. Le diamètre des zones n⁺⁺ ainsi obtenues est de 40 micromètres pour un tir laser. Des zones de plus grandes dimensions peuvent être obtenues en réitérant le tir laser en déplaçant le point d'impact.
4. Des contacts électriques sont réalisés par métallisation par sérigraphie. Le contact n sous forme de lignes juxtaposées est constitué d'une pâte d'argent (PV142 de chez Dupont), ouverture masque 70 micromètres, pas des ouvertures de 2.1 millimètres, alignée sur les zones n⁺⁺.
   Le contact p est constitué d'une pâte d'aluminium (PASE1202 de chez Monocrystal) déposée sur toute la surface inférieure du substrat. Ce contact constitue une zone de fort dopage p permettant d'assurer le phénomène de BSF.
5. La formation par diffusion de l'émetteur n⁺ et des contacts n et des contacts p sont réalisés en une seule étape dans un four infrarouge de marque Centrotherm, à une température de 1000°C, et une vitesse de passage de 4000 mm/min.

## Revendications

1. Procédé de réalisation d'une cellule photovoltaïque à émetteur sélectif, comprenant les étapes suivantes :
- dépôt d'une couche antireflet (7) comprenant des dopants de type n sur un substrat (1) de silicium de type p, ledit dépôt étant réalisé en présence d'un composé chimique permettant d'accélérer la diffusion des atomes dopants de type n dans ledit substrat (1) ;
- surdopage d'au moins une zone du substrat (1) de manière à réaliser au moins un émetteur surdopé n⁺⁺ (6), par diffusion ponctuelle des dopants n d'au moins une zone de la couche antireflet (7) ;
- dépôt :
∘ d'au moins un matériau conducteur de contact n (3) sur le au moins un émetteur surdopé n⁺⁺ (6) ; et
∘ d'au moins un matériau conducteur de contact p (4) sur la face du substrat (1) opposée à celle comprenant la couche antireflet (7) ;
- réalisation des contacts n (3) et des contacts p (4) simultanément à la réalisation d'un émetteur n⁺ (5) par un recuit apte à diffuser au sein du substrat des dopants n de la couche antireflet (7).

2. Procédé de réalisation d'une cellule photovoltaïque à émetteur sélectif selon la revendication 1, ***caractérisé* en ce que** la couche antireflet (7) est réalisée en nitrure de silicium.

3. Procédé de réalisation d'une cellule photovoltaïque à émetteur sélectif selon la revendication 1 ou 2, ***caractérisé* en ce que** la couche antireflet (7) est dopée au phosphore.

4. Procédé de réalisation d'une cellule photovoltaïque à émetteur sélectif selon l'une des revendications 1 à 3, ***caractérisé* en ce que** le composé chimique permettant d'accélérer la diffusion des atomes dopants de type n est l'ammoniac, NH₃.

5. Procédé de réalisation d'une cellule photovoltaïque à émetteur sélectif selon l'une des revendications 1 à 4, ***caractérisé* en ce que** le au moins un émetteur n⁺⁺ (6) est réalisé par dopage laser, avantageusement par laser pulsé, plus avantageusement encore par laser pulsé dont la longueur d'onde peut être choisie dans le domaine s'étendant des ultraviolets aux infrarouges.

6. Procédé de réalisation d'une cellule photovoltaïque à émetteur sélectif selon la revendication 5, ***caractérisé* en ce que** la durée des impulsions laser est comprise entre 10 ps et 1 µs.

7. Procédé de réalisation d'une cellule photovoltaïque à émetteur sélectif selon l'une des revendications 5 à 6, ***caractérisé* en ce que** le laser présente une longueur d'onde sensiblement égale à 515 nm.

8. Procédé de réalisation d'une cellule photovoltaïque à émetteur sélectif selon l'une des revendications 1 à 7, ***caractérisé* en ce que** les matériaux conducteurs de contact n ou p sont déposés par sérigraphie.

9. Procédé de réalisation d'une cellule photovoltaïque à émetteur sélectif selon l'une des revendications 1 à 8, ***caractérisé* en ce que** l'émetteur n⁺ (5) et les contacts n (3) et p (4) sont réalisés simultanément par recuit dans un four infrarouge, à une température comprise entre 850 et 1050°C, et à une vitesse de passage comprise entre 2000 et 6500 mm/min.

10. Procédé de réalisation d'une cellule photovoltaïque à émetteur sélectif selon l'une des revendications 1 à 9, ***caractérisé* en ce que** le substrat (1) présente une épaisseur comprise entre 50 micromètres et 500 micromètres.

11. Procédé de réalisation d'une cellule photovoltaïque à émetteur sélectif selon l'une des revendications 1 à 10, ***caractérisé* en ce que** la couche antireflet (7) présente une épaisseur comprise entre 20 nanomètres et 100 nanomètres.

## Patentansprüche

1. Verfahren zur Herstellung einer photovoltaischen Zelle mit selektivem Emitter mit den folgenden Schritten:
- Aufbringen einer Antireflexschicht (7) mit Dotierungsmitteln des n-Typs auf ein Siliziumsubstrat (1) des p-Typs, wobei das Aufbringen in Anwesenheit einer chemischen Verbindung erfolgt, die es ermöglicht, die Diffusion der Dotierungsatome des n-Typs in dem Substrat (1) zu beschleunigen;
- Überdotieren mindestens eines Bereichs des Substrats (1), um mindestens einen n⁺⁺-überdotieren Emitter (6) durch punktuelle Diffusion der n-Dotierungsmittel mindestens eines Bereichs der Antireflexschicht (7) herzustellen;
- Aufbringen
∘ mindestens eines leitenden n-Kontaktmaterials (3) auf den mindestens einen n⁺⁺-überdotieren Emitter (6) und
∘ mindestens eines leitenden p-Kontaktmaterials (4) auf die Seite des Substrats (1), die derjenigen mit der Antireflexschicht (7) gegenüberliegt, und
- Herstellen der n-Kontakte (3) und der p-Kontakte (4) gleichzeitig mit der Herstellung eines n⁺-Emitters (5) durch ein Tempern, das geeignet ist, innerhalb des Substrats n-Dotierungsmittel aus der Antireflexschicht (7) zu diffundieren.

2. Verfahren zur Herstellung einer photovoltaischen Zelle mit selektivem Emitter nach Anspruch 1, **dadurch gekennzeichnet, dass** die Antireflexschicht (7) aus Siliziumnitrid hergestellt ist.

3. Verfahren zur Herstellung einer photovoltaischen Zelle mit selektivem Emitter nach Anspruch 1 oder 2, **dadurch gekennzeichnet, dass** die Antireflexschicht (7) mit Phosphor dotiert ist.

4. Verfahren zur Herstellung einer photovoltaischen Zelle mit selektivem Emitter nach einem der Ansprüche 1 bis 3, **dadurch gekennzeichnet, dass** es sich bei der chemischen Verbindung, welche die Beschleunigung der Diffusion der Dotierungsatome des n-Typs ermöglicht, um Ammoniak NH₃ handelt.

5. Verfahren zur Herstellung einer photovoltaischen Zelle mit selektivem Emitter nach einem der Ansprüche 1 bis 4, **dadurch gekennzeichnet, dass** der mindestens eine n⁺⁺-Emitter (6) mittels Laserdotierung, vorzugsweise mittels eines gepulsten Lasers, höchstvorzugsweise mittels eines gepulsten Lasers mit einer Wellenlänge, die in dem Spektrum von Ultraviolett bis Infrarot gewählt werden kann, hergestellt ist.

6. Verfahren zur Herstellung einer photovoltaischen Zelle mit selektivem Emitter nach Anspruch 5, **dadurch gekennzeichnet, dass** die Dauer der Laserpulse zwischen 10 ps und 1 µs liegt.

7. Verfahren zur Herstellung einer photovoltaischen Zelle mit selektivem Emitter nach einem der Ansprüche 5 bis 6, **dadurch gekennzeichnet, dass** der Laser eine Wellenlänge aufweist, die im Wesentlichen 515 nm beträgt.

8. Verfahren zur Herstellung einer photovoltaischen Zelle mit selektivem Emitter nach einem der Ansprüche 1 bis 7, **dadurch gekennzeichnet, dass** die leitenden n- bzw. p-Kontaktmaterialien mittels Serigrafie aufgetragen werden.

9. Verfahren zur Herstellung einer photovoltaischen Zelle mit selektivem Emitter nach einem der Ansprüche 1 bis 8, **dadurch gekennzeichnet, dass** der n⁺-Emitter (5) und die n-Kontakte (3) und p-Kontakte (4) gleichzeitig durch Tempern in einem Infrarotofen bei einer Temperatur zwischen 850 und 1.050 °C und einer Durchlaufgeschwindigkeit zwischen 2.000 und 6.500 mm/min hergestellt werden.

10. Verfahren zur Herstellung einer photovoltaischen Zelle mit selektivem Emitter nach einem der Ansprüche 1 bis 9, **dadurch gekennzeichnet, dass** das Substrat (1) eine Dicke zwischen 50 Mikrometern und 500 Mikrometern aufweist.

11. Verfahren zur Herstellung einer photovoltaischen Zelle mit selektivem Emitter nach einem der Ansprüche 1 bis 10, **dadurch gekennzeichnet, dass** die Antireflexschicht (7) eine Dicke zwischen 20 Nanometern und 100 Nanometern aufweist.

## Claims

1. A method of manufacturing a photovoltaic cell with a selective emitter, comprising the steps of:
- depositing an antireflection layer (7) comprising n-type dopants on a p-type silicon substrate (1), said deposition being performed in the presence of a chemical compound enabling to accelerate the diffusion of n-type dopant atoms in said substrate (1);
- overdoping at least one area of the substrate (1) to form at least one n⁺⁺ overdoped emitter (6) by local diffusion of the n dopants of at least one area of the antireflection layer (7);
- depositing:
∘ of at least one n-contact conductive material (3) on the at least one n⁺⁺ overdoped emitter (6); and
∘ at least one p-contact conductive material (4) on the surface of the substrate (1) opposite to that comprising the antireflection layer (7);
- forming the n contacts (3) and the p contacts (4) simultaneously to the forming of an n⁺ emitter (5) by an anneal capable of diffusing within the substrate n dopants from the antireflection layer (7).

2. The method of forming a photovoltaic cell with a selective emitter of claim 1, ***characterized in that*** the antireflection layer (7) is made of silicon nitride.

3. The method of forming a photovoltaic cell with a selective emitter of claim 1 or *2, **characterized in that*** the antireflection layer (7) is phosphorus-doped.

4. The method of forming a photovoltaic cell with a selective emitter of any of claims 1 to 3, ***characterized in that*** the chemical compound enabling to accelerate the diffusion of the n-type dopant atoms is ammonia, NH₃.

5. The method of forming a photovoltaic cell with a selective emitter of any of claims 1 to 4, ***characterized in that*** the at least one n⁺⁺ emitter (6) is formed by laser doping, advantageously by irradiation by pulsed laser, more advantageously still by pulsed laser having a wavelength which may be selected from the range extending from ultraviolet to infrared.

6. The method of forming a photovoltaic cell with a selective emitter of claim 5, ***characterized in that*** the laser pulses last from 10 ps to 1 µs.

7. The method of forming a photovoltaic cell with a selective emitter of any of claims 5 to 6, ***characterized in that*** the laser has a wavelength substantially equal to 515 nm.

8. The method of forming a photovoltaic cell with a selective emitter of any of claims 1 to 7, ***characterized in that*** the n- or p-contact conductive materials are deposited by silk screening.

9. The method of forming a photovoltaic cell with a selective emitter of any of claims 1 to 8, ***characterized in that*** the n⁺ emitter (5) and the contacts n (3) and p (4) are simultaneously formed by anneal in an infrared furnace, at a temperature between 850 and 1050°C, and at a passage speed between 2,000 and 6,500 mm/min.

10. The method of forming a photovoltaic cell with a selective emitter of any of claims 1 to 9, ***characterized in that*** the substrate (1) has a thickness between 50 micrometers and 500 micrometers.

11. The method of forming a photovoltaic cell with a selective emitter of any of claims 1 to 10, ***characterized in that*** the antireflection layer (7) has a thickness between 20 nanometers and 100 nanometers.
